# EUROPÄISCHE PATENTSCHRIFT

(11) **EP 2 259 081 B1**
(45) Veröffentlichungstag und Bekanntmachung des Hinweises auf die Patenterteilung: **22.08.2012**
(21) Anmeldenummer: 10005738.9
(22) Anmeldetag: 02.06.2010
(51) Int. Cl.: G01R 33/02, G01R 33/025, G01R 33/00

(54) **Magnetfeldkompensation**
Magnetic field compensation
Compensation de champ magnétique

(30) Priorität: 05.06.2009 DE 102009024268
(43) Veröffentlichungstag der Anmeldung: 08.12.2010
(73) Patentinhaber: Integrated Dynamics Engineering GmbH, 65479 Raunheim (DE)
(72) Erfinder: Wallauer, Steffen, 55595 Roxheim (DE)
(74) Vertreter: Herden, Andreas F.

(56) Entgegenhaltungen:
- EP-A1- 1 840 681
- EP-A1- 1 860 451
- EP-A1- 1 873 543
- DE-A1- 3 308 717
- US-A- 4 198 021
- US-A- 5 225 999
- US-A- 5 465 012
- US-A- 5 586 064
- US-A1- 2005 099 177

## Beschreibung

### Gebiet der Erfindung

Die Erfindung bezieht sich auf eine Magnetfeldkompensationseinrichtung, insbesondere auf eine Magnetfeldkompensationseinrichtung mit einem magnetoresistiven Magnetfeldsensor.

### Hintergrund der Erfindung

Einrichtungen zur Kompensation magnetischer Felder sind bekannt siehe z.B. US 2005/099177 oder US 5225999 oder US 5586064. Derartige Einrichtungen verwenden im Allgemeinen einen Feedback-Regelungskreis, wobei von einem oder mehreren Sensoren eine Störfeldamplitude gemessen wird. Das gemessene Signal wird nach Bearbeitung durch eine Regelungseinrichtung als Steuersignal auf Helmholtzspulen gegeben, die mittels Abstrahlung eines magnetischen Kompensationsfeldes die Störfeldamplitude am Ort des Sensors minimieren.

Das zu kompensierende Magnetfeld kann das Erdmagnetfeld sein oder von anderen in der Umgebung befindlichen Einrichtungen erzeugt werden.

Neben ausschließlich analogen Feedbacksystemen können auch ausschließlich digital arbeitende Feedbacksysteme eingesetzt werden. Um die mit rein analog und rein digital arbeitenden Systemen jeweils verbundenen Nachteile zu vermeiden, wurden auch Hybridsysteme entwickelt, siehe z.B. auch EP1840681 und US4198021.

So beschreibt das Patent EP 1 873 543 A1 der Anmelderin ein solches Hybridsystem zur Kompensation von Magnetfeldern.

Bei diesem System kommt zur Messung des Magnetfeld ein Kombinationssensor zum Einsatz, der sowohl Spulenaufnehmer als auch Fluxgatesensoren umfasst. Die Signale der Spulenaufnehmer werden hierbei für den analogen Anteil der Regelung verwendet, die Signale der Fluxgatesensoren für den digitalen Anteil.

Bei Spulenaufnehmern wird die durch ein externes Magnetfeld in einer Spule induzierte Spannung gemessen.

Fluxgatesensoren gibt es sowohl in zweiachsiger als auch in dreiachsiger Ausführung. Derartige Sensoren können magnetische Felder senkrecht zu einer Ebene oder auch in alle Raumrichtungen messen. Dabei befinden sich auf zwei ferromagnetischen Kernen jeweils drei Spulen. Ein Dreiecksgenerator erzeugt einen Strom, der durch die Anregungsspulen fließt. In den ferromagnetischen Kernen wird durch diesen Strom ein Magnetfeld aufgebaut. Die Veränderung des magnetischen Flusses induziert in den sogenannten Pickup-Spulen Spannungen. Sofern kein externes Eeld anliegt, ist die Differenz der Spannungen der pickup-Spulen Null. Sobald ein externes magnetisches Feld aufgebaut wird, entsteht eine Differenzspannung

Derartige Hybridsysteme mit einem analogen und einem digitalen Regelkreis weisen den Nachteil auf, dass sowohl Spulenaufnehmer als auch Fluxgatesensoren in einem Gehäuse untergebracht werden müssen. Die räumliche Nähe der Fluxgatesensoren zu den Spulenaufnehmern führt dabei zu einem Übersprechen der Chopperfrequenz zu den Spulen und damit zu unerwünschten Frequenzkomponenten im Spulensignal. Unter Chopperfreuqenz wird hierbei die Frequenz verstanden, mit welcher die Anregungsspulen des Fluxgatesensors betrieben werden. Die einzelnen Sensoren müssen daher innerhalb des Gehäuse sorgfältig angeordnet werden, um dieses Übersprechen klein zu halten. Dennoch lässt sich eine Bauform von ca. 2cmx2cmx8cm und ein Gewicht von 300g kaum unterbieten.

### Aufgabe der Erfindung

Die Erfindung hat sich daher die Aufgabe gestellt, einen Sensor zum Einsatz in einer Magnetfeldkompensationseinrichtung bereitzustellen, dessen Abmessungen deutlich geringer sind, als bei herkömmlichen Sensoren.

### Kurze Beschreibung der Erfindung

Die Aufgabe der Erfindung wird bereits durch eine Einrichtung zur Magnetfeldkompensation nach Anspruch 1 gelöst.

Bevorzugte Ausführungsformen und Weiterbildungen der Erfindung sind den jeweiligen Unteransprüchen zu entnehmen.

Danach ist eine Magnetfeldkompensationseinrichtung vorgesehen, welche einen Magnetfeldsensor und einen Messverstärker zur Bearbeitung des vom Sensor gelieferten Messsignals umfasst. Der Magnetfeldsensor ist hierbei als ein einziger magnetoresistiver Sensor ausgebildet, dem mindestens zwei Messverstärkerkreise zugeordnet sind, d.h. Schaltungen zur Verstärkung der gemessenen Signale, damit diese Kraftverstärkern zur Erregung der Kompensationsspulen zugeführt werden können.

Die Funktionsweise eines magnetoresistiven Sensors beruht auf magnetoresisitiven Effekten. Bei diesen ändert sich der elektrische Widerstand eines Materials durch Anlegen eines äußeren Magnetfeldes, proportional zu dessen Amplitude. Zu den magnetoresisitiven Effekten gehören insbesondere der anisotrope magnetoresistive Effekt (AMR-Effekt), der "gigantische" magnetoresistive Effekt (GMR-Effekt), der CMR-Effekt, der TMR-Effekt und der planare Hall-Effekt. Hierbei wird unterschieden zwischen magnetoresistiven Effekten in nicht-magnetischen Materialien (Hall-Effekt), in magnetischen Materialien (z.B. AMR-Effekt) und in hybriden Materialien aus nicht-magnetischen und magnetischen Materialien (z.B. GMR-, EMR-Effekt).

Aus Gründen der Klarheit sei betont, dass es sich.bei dem gewöhnlichen Hall-Effekt, im Gegensatz zum planaren Hall-Effekt, um keinen magnetoresistiven Effekt handelt.

In einer bevorzugten Ausführungsform der Erfindung ist der magnetoresistive Sensor als dreiachsiger Sensor ausgebildet.

Mittels beigestellter low-noise Elektronik können durch eine derartige Einrichtung Sensorsignale von DC bis 170kHz oder mehr bereitgestellt werden.

Von den beiden Messverstärkerkreisen ist einer als analoger Breitband-Regler und der andere als digitaler Breitband-Regler ausgebildet. Vor dem digitalen Breitband-Regler ist ein Analog-Digital-Wandler angeordnet, hinter dem digitalen Breitband-Regler ein Analog-Digital-Wandler. Der Begriff "Breitband" ist hier im Sinne eines großen

Frequenzspektrums oder "breiten" Frequenzbandes zu verstehen, in dem die Signale liegen und verarbeitet werden können.

Erfindungsgemäß können beide Messverstärkerkreise parallel betrieben werden. Alternativ kann der Magnetfeldsensor aber auch zwischen den beiden Messverstärkerkreisen umschaltbar sein, so dass zur gleichen Zeit jeweils nur der digitale oder der analoge Messverstärderkreis genutzt wird.

In einer bevorzugten Ausführungsform der Erfindung umfasst der digitale Messverstärkerkreis mehrere parallel geschaltete Regler für unterschiedliche Frequenzbereiche. Das Messsignal des Magnetfeldsensors wird auf diese Weise in Abhängigkeit von seinen Frequenzanteilen verschiedenen Reglern zugeführt.

In einer weiteren Ausführungsform ist dem digitalen Breitband-Regler ein Tiefpass für einen Frequenzbereich von 0 - 1 kHz vorgeschaltet, dem analogen. Breitband-Regler ein Hochpass für einen Frequenzbereich von 1 kHz bis mindestens 170 kHz.

Die Frequenz, ab der das vom Magnetfeldsensor bereit gestellte Messsignal nicht mehr dem digitalen, sondern dem analogen Breitband-Regler zugeführt wird, kann auch in der Größenordnung von 20 Hz liegen, so dass dem digitalen Breiband-Regler ein Tiefpass für Frequenzen unterhalb von 20 Hz vorgeschaltet ist, und dem analogen Breitband-Regler ein Hochpass für Frequenzen oberhalb von 20 Hz.

In einer weiteren Ausführungsform der Erfindung wird einem der beiden Messverstärkerkreise ein wählbarer Hochpass vorgeschaltet, so dass die Frequenz, ab der das vom Magnetfeldsensor bereit gestellte Messsignal nicht mehr dem digitalen, sondern dem analogen Breitband-Regler zugeführt wird, manuell einstellbar ist.

Zur Magnetfeldkompensation wird der Magnetfeldsensor innerhalb von Helmholtzspulen angeordnet. Für jede der drei Raumachsen ist hierbei jeweils ein Paar von Helmholtzspulen vorgesehen. Die Ausgangssignale der Messverstärkerkreise werden als Steuerungssignale auf die Helmholtzspulen gegeben, so dass das am Ort des Magnetfeldsensors gemessene Magnetfeld kompensiert wird.

Statt der Paare von Helmholtzspulen kann auch eine Einzelspule je Raumachse verwendet werden.

Der erfindungsgemäße Magnetfeldsensor einschließlich seiner mindestens zwei Messverstärkerkreise kann in einer vergleichsweise kompakten Bauform bereit gestellt werden. Für eine Achse kann eine Single-Layer-Platine auf einem Bauraum von etwa 20mm x 4mm x 5mm bereit gestellt werden. Der erfindungsgemäße Magnetfeldsensor wird auch in dreiachsiger Ausführungsform deutlich kleiner und leichter als vergleichbare Sensoranordnungen zur Kompensation magnetischer Felder.

Kurze Beschreibung der Zeichnungen

### Es zeigen:

- Fig. 1:: eine Ausführungsform einer Magnetfeldmessanordnung, bei welcher ein
- analoger: Breitband-Regler zu einem digitalen
- Breitband-: Regler parallel geschaltet ist.
- Fig. 2:: eine Ausführungsform einer Magnetfeldmessanordnung, bei welcher ein
- analoger: Breitband-Regler parallel zu einem digitaler Breitband-Regleranordnung geschaltet ist,
- die: mehrere Einzelfreuqenz-Regelkreise umfasst,
- Fig. 3:: eine Ausführungsform einer Magnetfeldmessanordnung, bei welcher ein Breitband-Regler einen wählbaren
- Hochpass: umfasst,
- Fig. 4:: eine Ausführungsform einer Magnetfeldmessanordnung mit einer Digitalregleranordnung und Aufteilung
- in: Einzelregler für Einzelfrequenzen,
- Fig. 5:: eine Magnetfeldkompensationsanordnung, und
- Fig 6:: ein Blockdiagramm einer Messanordnung mit magnetoresistivem Sensors.

### Detaillierte Beschreibung der Erfindung

Im Folgenden wird die Erfindung unter Bezugnahme auf die beigefügten Figuren anhand beispielhafter Ausführungsformen näher beschrieben, wobei gleiche Bezugszeichen sich auf gleiche Bauteile beziehen.

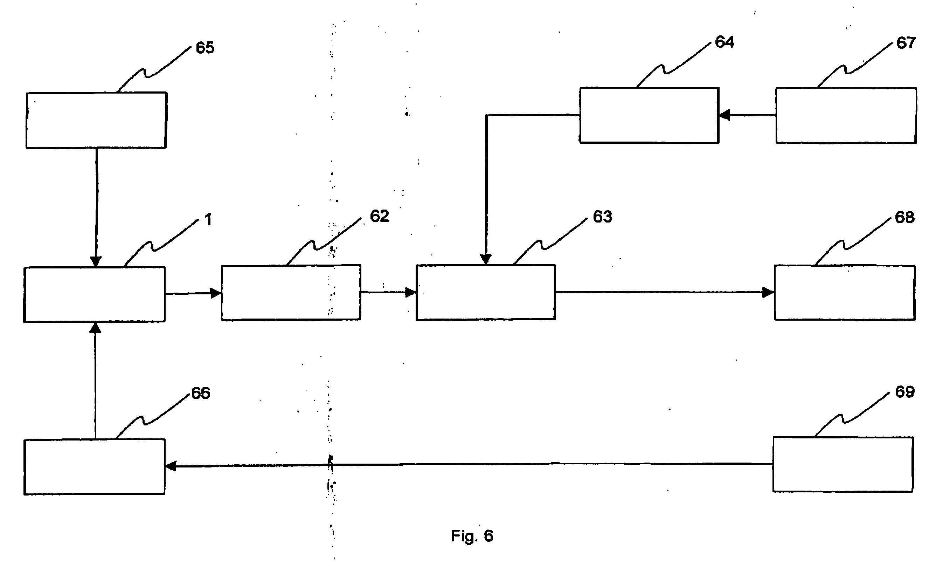

Fig. 6 zeigt in einem Blockdiagramm eine Messanordnung mit einem magnetoresistiven Sensor. Ein magnetoresistiver Sensor 1 in Gestalt eines Chips wird von einer Spannungsquelle 65 mit einer Referenzspannung von 5V versorgt. Ein Resetschaltkreis 66 ermöglicht ein "Power-Up" sowie ein externes Reset, wodurch aufgrund eines Resetsignals 69 eine Flipspule zum Entmagnetisieren des magnetoresistiven Sensor Chips aktiviert wird. Das Ausgangssignal des Sensors 1 wird einem Instrumentenverstärker 62 zugeführt, der das Ausgangssignal verstärkt. Typischerweise liegt der Verstärkungsfaktor bei etwa 200. Das Ausgangssignal des Instrumentenverstärkers 62 wird einem Summationsverstärker 63 mit Tiefpassfilter zugeführt. Der Verstärkungsfaktor des Summationsverstärkers 63 beträgt typischerweise bei 36. Das Ausgangssignal 68 des Summationsverstärkers 63 und damit der Messanordnung ist digital und hat typischerweise eine Frequenz von 120 kHz. Der Level des Ausgangssignals liegt typischerweise bei 140mV pro µT des gemessenen Magnetfeldes. Für jede Raumachse ist eine Messanordnung gemäß Fig. 6 vorgesehen.

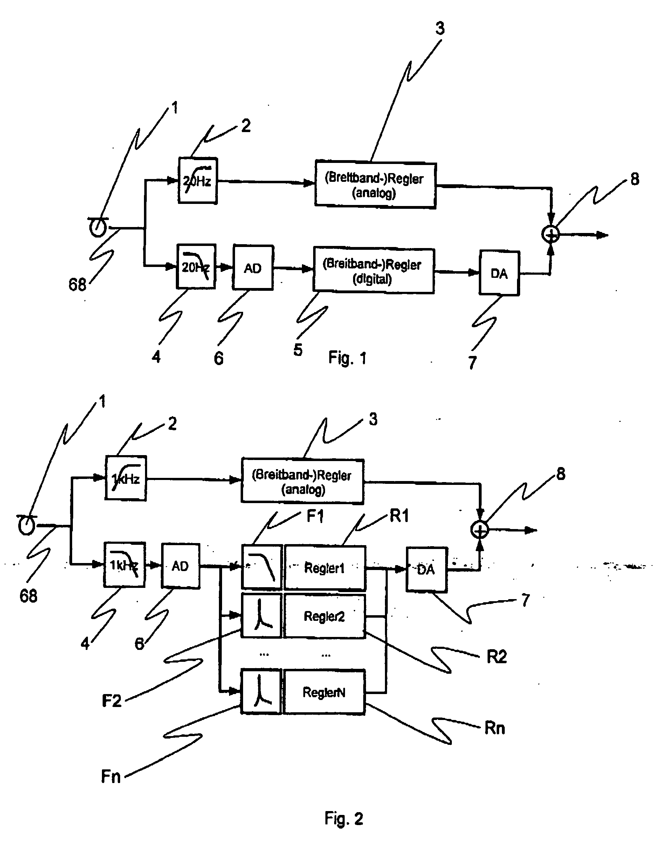

Fig. 1 zeigt eine hybride Magnetfeldmessanordnung mit einem einzigen magnetoresisistiven Magnetfeldsensor 1, dessen Ausgangssignal 68 in zwei parallel angeordnete Messverstärkerzweigen eingespeist wird. Jeder dieser Messverstärkerkreise umfasst ein, zwei oder drei Verstärkerkanäle, je nach der Anzahl der Sensorachsen, d.h. das jeweilige Signal besitzt ein oder mehrere Komponenten. Der in Fig. 1 oben befindliche Verstärkerzweig umfasst einen analogen Breitband-Regler 3 mit vorgeschaltetem Hochpassfilter 2. Der in Fig. 1 unten befindliche Messverstärkerzweig weist einen Tiefpassfilter 4 auf, dessen Ausgangssignal in einen AD-Wandler 6 eingespeist wird, dem ein digitaler Breitband-Regler 5 nachgeschaltet ist. Das digitale Ausgangssignal des Breitband-Reglers 5 wird von einem DA-Wandler 7 in ein analoges Signal umgewandelt.

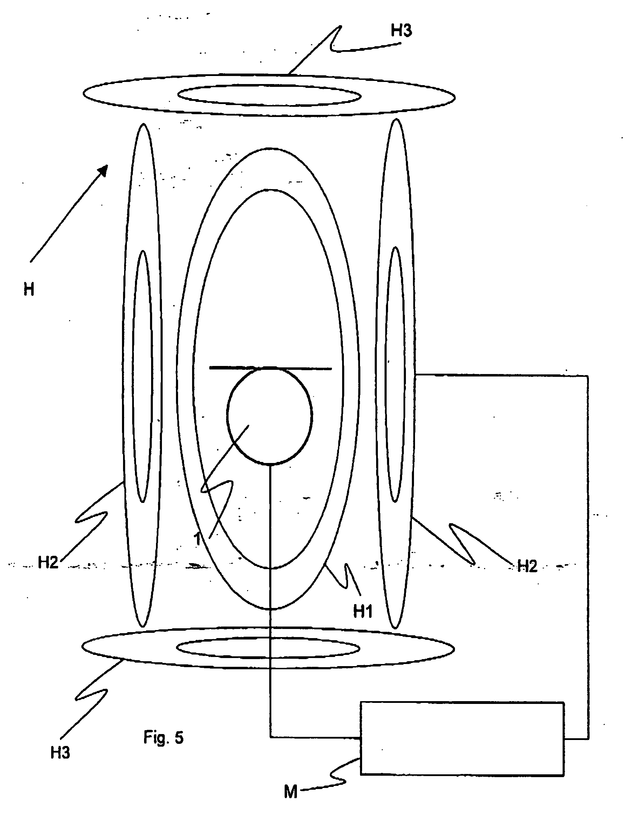

Die Ausgangssignale der beiden parallel angeordneten Messverstärkerzweige werden von einem Addierer 8 summiert und einer Helmholtzspulenaornung H mit Helmholtzspulenpaaren H1, H2, H3 (Fig. 5) zugeführt, um eine Magnetfeldkompensationsanordnung zu bilden. Statt der Paare von Helmholtzspulen kann auch eine Einzelspule je Achse verwendet werden. Der analoge und der digitale Messverstärkerzweig ist in Fig. 5. zu dem Messverstärker M zusammengefasst.

Die Komponenten des Ausgangssignals der Magnetfeldmessanordnung können zur Kompensation von Magnetfeldern verwendet werden, indem die Signalkomponenten zur Steuerung des jeweiligen Stroms in den Helmholtzspulen H1, H2, H3 oder Einzelspulen verwendet werden. Diese Spulen umgeben den Messort und somit den Magnetfeldsensor 1. Es findet ein Feedbackregelungskonzept Anwendung, bei welchem die Störfeldamplitude des örtlichen Magnetfelds vom Sensor 1 gemessen wird. In Abhängigkeit von der Größe dieser Störfeldamplitude werden entsprechend geregelte Signalkomponenten auf die Helmholtzspulen oder die Einzelspulen gegeben, so dass die Störfeldamplitude am Messort minimiert wird.

Analoge Regler und digitale Regler haben ihre jeweiligen Vorteile und Nachteile. Analoge Regler können für größere Bandbreiten gebaut werden, während digitale Regler eine größere Wandelbarkeit hinsichtlich ihrer Steuercharakteristik aufweisen oder ein weiteres Regelprogramm benutzt wird. Aufgrund des analogen Teils der Magnetfeldmessanordnung wird der Nachteil von rein digitalen Systemen vermieden. Hierzu gehört, dass diese nicht nur eine AD-Wandlung der Sensorsignale vornehmen müssen, sondern auch die Ausgangssignale zurück in analoge Signale verwandeln müssen.

Aufgrund dieser AD-DA-Wandlung ergibt sich wegen der Abstastung der Signale ein Phasenverlust, der in praktischen Regelungssystemen die Bandbreite der Regelung begrenzt. Derzeit erhältliche digitale Systeme erreichen Bandbreiten von maximal 1kHz.

Die Kombination eines analogen mit einem digitalen Messverstärkerzweig vermeidet diesen Nachteil. Dabei wird das Ausgangssignal des Magnetfeldsensors 1 in seine Frequenzanteile aufgespaltet. In der in Fig. 1 gezeigten Ausführungsform werden Frequenzen oberhalb von 20 Hz mittels des Hochpassfilters 2 dem analogen Breitband-Regler 3 zugeführt und Frequenzen unterhalb von 20 Hz dem digitalen Messverstärkerzweig mit Tiefpassfilter 4, Wandlern 6, 7 und digitalem Regler 5. Andere Grenzfrequenzen können gewählt werden, um beispielsweise den Wirkungsgrad der beiden parallel angeordneten Messverstärkerzweige zu optimieren.

Fig. 2 zeigt eine weitere Ausführungsform einer hybriden Magnetfeldmessanordnung. Auch hier wird das Ausgangssignal 68 des magnetoresistiven Magnetfeldsensors 1 in zwei parallel angeordnete Messverstärkerzweige eingespeist, deren in Fig. 2 oberer Zweig wiederum einen analogen Breitband-Regler 3 mit vorgeschaltetem Hochpassfilter 2 umfasst. Im unteren Zweig gibt es eine Parallelschaltung von mehreren Reglern R1, R2, ..., Rn, denen jeweils Filter F1, F2, ..., Fn vorgeschaltet sind. Die Ausgangssignale der Regler R1, R2, ...,Rn werden zusammengefasst und von dem DA-Wandler 7 in analoge Signale umgewandelt und dem Addierer 8 zugeführt.

Bevorzugt werden die Filter F1, F2, ... , Fn wie folgt eingestellt:
F1: Tiefpass 20 Hz
F2: 16,67 Hz Bandpass
F3: 50 Hz (bzw. 60 Hz) Bandpass, Netzfrequenz
F4-Fn: Ganzzahlige Vielfache der Netzfrequenz, also 2*50Hz/2*60Hz, 3*50Hz, 3*60Hz, usw. als Bandpass.

Die Aufteilung des Ausgangssignals 68 des Sensors 1 mittels Tiefpassfilter 4 und Hochpassfilter 2 wird derart gewählt, dass für beide Bereiche, d.h. sowohl für den digitalen, tieffrequenten als auch den analogen, hochfrequenten Bereich der jeweils optimale Wirkungsgrad erreicht wird. Typischerweise sind diese Frequenzbereiche 0-2 kHz, 2 kHz - 170 kHz oder 0-4 kHz, 4 kHz - 170kHz oder mehr.

Das Ausgangssignal der Magnetfeldmessanordnung wird zur Kompensation von Magnetfeldern verwendet, wie beschrieben.

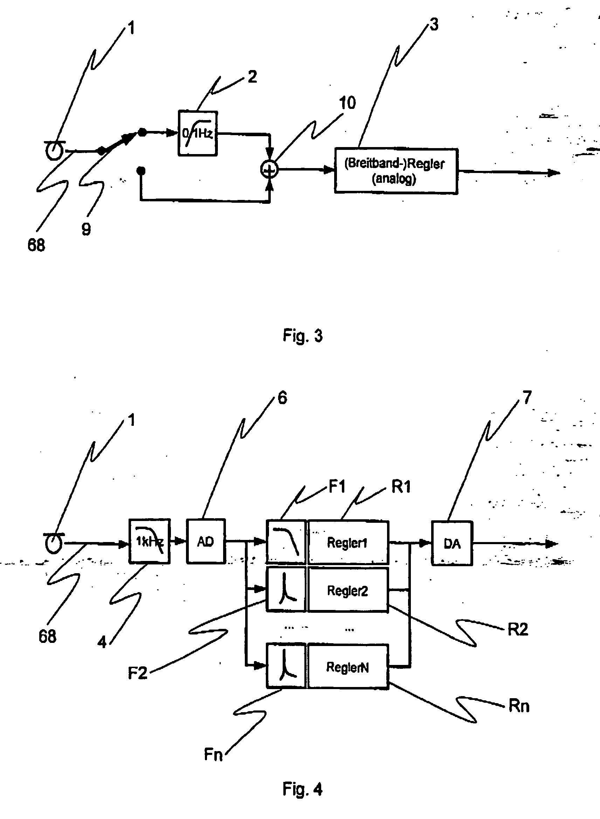

Fig. 3 zeigt ein weiteres Ausführungsbeispiel einer Magnetfeldmessanordnung, nämlich den analogen Zweig.gemäß Fig. 1. Der dem analogen Breitband-Regler 3 vorgeschaltete Hochpassfilter 2 kann mittels Umlegen eines Schalters 9 überbrückt werden, so dass das Ausgangssignal 68 des magnetoresistiven Magnetfeldsensors 1 den analogen Breitband-Regler 3 ungefiltert in voller Bandbreite erreicht. Das gefilterte und das ungefilterte Ausgangssignal 68 des Magnetfeldsensors 1 werden von einem Addierer 10 zusammengefasst.

Der vorgeschaltete Hochpassfilter 2 dient einer Bandbegrenzung des Ausgangssignals 68 des Sensors 1. Vorzugsweise liegt die Filterfrequenz des Hochpassfilters 2 in dieser Ausführungsform bei ca, 0,1 1 Hz. Der Hochpassfilter 2 wird verwendet, wenn eine DC-Kompensation gewünscht wird. Ist dies nicht der Fall, so wird der Hochpassfilter 2 mittels manuellem Umlegen des Schalters 9 überbrückt. Alternativ kann der Schalter 9 auch mittels Software betätigt werden.

Auch hier werden die Komponenten des Ausgangssignals der Magnetfeldmessanordnung zur Kompensation von Magnetfeldern verwendet.

Fig. 4 zeigt ein Ausführungsbeispiel einer digitalen Magnetfeldmessanordnung, die im Prinzip dem unteren Messverstärkerzweig in Fig. 2 entspricht. Die Anordnung umfasst einen Tiefpassfilter 4, dessen Ausgangssignal von einem AD-Wandler in ein digitales Signal umgewandelt wird, das in die parallel angeordneten, einzelnen Regler R1, R2, ..., Rn mit den vorgeschalteten Filtern F1, F2, ..., Fn eingespeist wird. Die Filterfrequenz des Tiefpassfilters 4 beträgt vorzugsweise 1 - 5 kHz. Die Filter F1, F2, ..., Fn teilen das Eingangssignal in Abhängigkeit von einzelnen Frequenzen auf die Regler R1, R2, ..., Rn auf. Die Frequenzen werden in der bereits beschriebenen Weise auf die Filter F1, F2, ..., Fn aufgeteilt. Die Ausgangssignale der Regler R1, R2, ...,Rn werden von einem DA-Wandler 7 in analoge Signale umgewandelt, um zur Kompensation von Magnetfeldern verwendet zu werden.

Fig. 5 zeigt den magnetoresistiven Magnetfeldsensor 1 in einer Magnetfeldkompensationseinrichtung H. Diese umfasst ein bis drei Paare von Helmholtzspulen H1, H2, H3. jedes Paar von Helmholtzspulen H1, H2, H3-erzeugt jeweils ein in eine der drei Raumrichtungen zeigendes Magnetfeld. Im zentralen Bereich zwischen den Paaren der Helmholtzspulen H1, H2, H3 ist der magnetoresistive Magnetfeldsensor 1 angeordnet. Die drei Komponenten der Messsignale 68 des Sensors 1 werden an eine Magnetfeldmesseinrichtung M weitergeleitet, wie mit Fig. 1 - 4 beschrieben. Die Messsignale werden verstärkt und gegebenenfalls bearbeitet, bevor sie zu der Magnetfeldkompensationseinrichtung rückgeführt werden. Dabei werden die passenden Komponenten der Signale als Steuersignale für die Paare von Helmholtzspulenpaaren H1, H2, H3 benutzt.

In einer alternativen Ausführungsform werden statt der Paare von Helmholtzspulen Einzelspulen je Raumachse verwendet.

## Patentansprüche

1. Magnetfeldkompensationseinrichtung umfassend
- eine Magnetfeldmessanordnung mit einem Magnetfeldsensor und Messverstärkermittel, wobei der Magnetfeldsensor als ein einziger magnftoresistiver Sensor (1) ausgebildet ist, **gekennzeichnet dadurch dass** dem sensor mindestens zwei parallel geschaltete Messverstärkerkreise (3, 5) zugeordnet sind, von denen der eine als analoger Breitband-Regler (3) und der andere als digitaler Breitband-Regler (5) ausgebildet sind.

2. Magnetfeldkompensationseinrichtung nach Anspruch 1, wobei der magnetoresistive Sensor (1) dreiachsig ausgebildet ist.

3. Magnetfeldkompensationseinrichtung nach Anspruch 1 oder 2, wobei der Magnetfeldsensor (1) zwischen den Messverstärkerkreisen umschaltbar ist.

4. Magnetkompensationseinrichtung nach einem der Ansprüche 1 bis 3, wobei der digitale Breitband-Regler (5) mehrere parallel geschaltete Regler (R1, R2, ..., Rn) für unterschiedliche Frequenzbereiche (F1, F2, F3) umfasst.

5. Magnetfeldkompensationseinrichtung nach einem der Ansprüche 1 - 4, wobei ein digitaler Breitband-Regler (5) mit einem vorgeschalteten Tiefpass (4) von 0 - 1 kHz und ein analoger Breitband-Regler (3) mit einem vorgeschalteten Hochpass (2) von 1 kHz bis wenigstens 170 kHz vorgesehen sind.

6. Magnetfeldkompensationseinrichtung nach einem der Ansprüche 1 - 9, wobei ein digitaler Breitband-Regler (5) mit einem vorgeschalteten Tiefpass (4) für Frequenzen unterhalb 20 Hz und ein analoger Breitband-Regler (3) mit einem vorgeschalteten Hochpass (2) für Frequenzen oberhalb 20 Hz vorgesehen sind.

7. Magnetfeldkompensationseinrichtung nach einem der Ansprüche 1 - 6, wobei einem der Messverstärkerkreise ein wählbarer Hochpass (2) vorgeschaltet ist.

8. Magnetfeldkompensationseinrichtung nach einem der Ansprüche 1 - 7, wobei der magnetoresistive Sensor von einer Helmholtzspulenanordnung (H) umgeben ist.

9. Magnetfeldkompensationseinrichtung nach einem der Ansprüche 1 - 8, wobei der magnetoresistive Sensor (1) von einer Einzelspulenanordnung umgeben list.

## Claims

1. Magnetic field compensation device, comprising
- a magnetic field measuring arrangement having a magnetic field sensor and measuring amplifying means, wherein the magnetic field sensor is formed as an individual magneto-resistive sensor (1), **characterised in that** the sensor is allocated at least two measuring amplifying circuits (3, 5) connected in parallel, of which one is formed as an analogue broadband controller (3) and the other is formed as a digital broadband controller (5).

2. Magnetic field compensation device as claimed in Claim 1, wherein the magneto-resistive sensor (1) is formed to be triaxial.

3. Magnetic field compensation device as claimed in Claim 1 or 2, wherein the magnetic field sensor (1) can be switched between the measuring amplifying circuits.

4. Magnetic field compensation device as claimed in any one of Claims 1 to 3, wherein the digital broadband controller (5) includes several controllers (R1, R2, ..., Rn), connected in parallel, for different frequency ranges (F1, F2, F3).

5. Magnetic field compensation device as claimed in any one of Claims 1 to 4, wherein a digital broadband controller (5) is provided with a low-pass filter (4), connected upstream, of 0-1 kHz and an analogue broadband controller (3) is provided with a high-pass filter (2), connected upstream, of 1 kHz to at least 170 kHz.

6. Magnetic field compensation device as claimed in any one of Claims 1 to 4, wherein a digital broadband controller (5) is provided with a low-pass filter (4), connected upstream, for frequencies below 20 Hz and an analogue broadband controller (3) is provided with a high-pass filter (2), connected upstream, for frequencies above 20 Hz.

7. Magnetic field compensation device as claimed in any one of Claims 1 to 6, wherein a selectable high-pass filter (2) is connected upstream of one of the measuring amplifying circuits.

8. Magnetic field compensation device as claimed in any one of Claims 1 to 7, wherein the magneto-resistive sensor is surrounded by a Helmholtz coil arrangement (H).

9. Magnetic field compensation device as claimed in any one of Claims 1 to 8, wherein the magneto-resistive sensor (1) is surrounded by a single coil arrangement.

## Revendications

1. Dispositif de compensation de champ magnétique, comprenant
- un dispositif de mesure de champ magnétique avec un capteur de champ magnétique et un moyen amplificateur de mesure, le capteur de champ magnétique étant conçu sous forme d'un unique capteur (1) magnétorésistif, **caractérisé en ce qu'**au moins deux circuits amplificateurs de mesure (3, 5) montés en parallèle sont attribués au capteur, capteurs dont l'un est conçu sous forme de régulateur analogique à large bande (3) et l'autre de régulateur numérique à large bande (5).

2. Dispositif de compensation de champ magnétique selon la revendication 1, le capteur (1) magnétorésistif étant conçu avec trois axes.

3. Dispositif de compensation de champ magnétique selon la revendication 1 ou 2, le capteur de champ magnétique (1) pouvant être commuté entre les circuits amplificateurs de mesure.

4. Dispositif de compensation de champ magnétique selon l'une des revendications 1 à 3, le régulateur numérique à large bande (5) comprenant plusieurs régulateurs (R1, R2, ..., Rn) montés en parallèle pour différentes plages de fréquences (F1, F2, F3).

5. Dispositif de compensation de champ magnétique selon l'une des revendications 1 à 4, un régulateur numérique à large bande (5) étant prévu avec un filtre passe-bas (4) placé en amont de 0 à 1 kHz et un régulateur analogique à large bande (3) étant prévu avec un filtre passe-haut (2) placé en amont de 1 kHz jusqu'à au moins 170 kHz.

6. Dispositif de compensation de champ magnétique selon l'une des revendications 1 à 4, un régulateur numérique à large bande (5) étant prévu avec un filtre passe-bas (4) monté en amont pour des fréquences inférieures à 20 Hz et un régulateur analogique à large bande (3) étant prévu avec un filtre passe-haut (2) placé en amont pour des fréquences supérieures à 20 Hz.

7. Dispositif de compensation de champ magnétique selon l'une des revendications 1 à 6, un filtre passe-haut (2) sélectionnable étant placé en amont de l'un des circuits amplificateurs de mesure.

8. Dispositif de compensation de champ magnétique selon l'une des revendications 1 à 7, le capteur magnétorésistif étant entouré d'un agencement de bobine de Helmholtz (H).

9. Dispositif de compensation de champ magnétique selon l'une des revendications 1 à 8, le capteur (1) magnétorésistif étant entouré d'un agencement de bobine individuel.
